(19) Europäisches Patentamt / European Patent Office / Office européen des brevets

(11) **EP 3 170 205 B1**

(12) **FASCICULE DE BREVET EUROPEEN**

(45) Date de publication et mention
de la délivrance du brevet:
**12.12.2018 Bulletin 2018/50**

(21) Numéro de dépôt: **15738351.4**

(22) Date de dépôt: **16.07.2015**

(51) Int Cl.:
**H01L 27/146** *(2006.01)*     **H04N 5/14** *(2006.01)*

(86) Numéro de dépôt international:
**PCT/EP2015/066226**

(87) Numéro de publication internationale:
**WO 2016/008959 (21.01.2016 Gazette 2016/03)**

(54) **DISPOSITIF DE DÉTECTION DE MOUVEMENT**

VORRICHTUNG ZUR DETEKTION EINER BEWEGUNG

DEVICE FOR DETECTING MOVEMENT

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **18.07.2014 FR 1456957**

(43) Date de publication de la demande:
**24.05.2017 Bulletin 2017/21**

(73) Titulaire: **Safran Electronics & Defense SAS
92100 Boulogne-Billancourt (FR)**

(72) Inventeur: **BOUSQUET, Marc
F-92100 Boulogne Billancourt (FR)**

(74) Mandataire: **Cabinet Le Guen Maillet
3, impasse de la Vigie
CS 71840
35418 Saint-Malo Cedex (FR)**

(56) Documents cités:
**DE-A1-102010 027 791     US-A1- 2002 158 294
US-A1- 2012 188 425**

**Description**

La présente invention concerne un dispositif de détection de mouvement, un système optronique comprenant ledit dispositif et un procédé de traitement de mouvements de hautes fréquences prenant en compte une utilisation dudit dispositif.

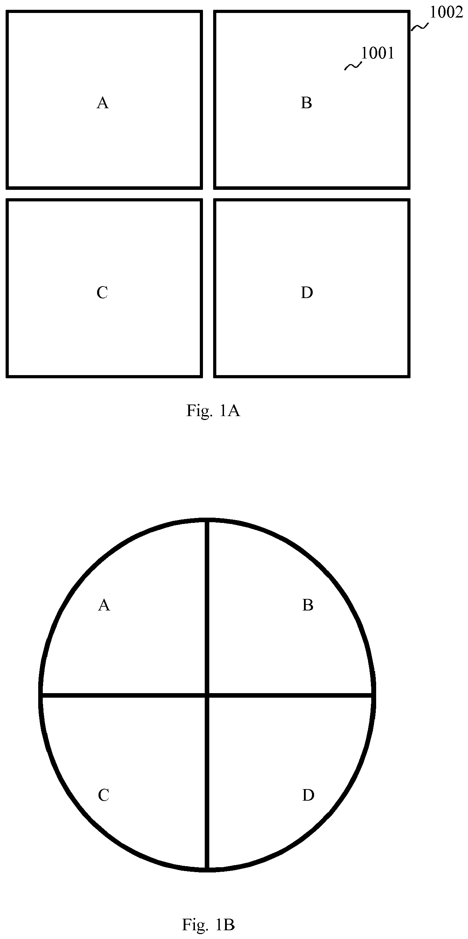

Les photodiodes multi-éléments (que nous appelons par la suite « photodiodes ME ») sont des dispositifs couramment utilisés pour effectuer des mises au point dans des lecteurs lasers tels que des lecteurs de CD ou de DVD ou dans des satellites pour asservir des lignes de visée laser. Une photodiode ME est en générale de forme carrée, comme représentée schématiquement en **Fig. 1A**, ou circulaire comme représentée en **Fig. 1B**.

Le document US2002/0158294 décrit un capteur d'images comprenant une pluralité de photodiodes.

Une photodiode ME comporte en général de deux à huit quadrants séparés par des espaces. Les Figs. 1A et 1B représentent des photodiodes ME comportant quatre quadrants notés *A*, *B*, *C* et *D*. Chaque quadrant comprend un capteur que nous appelons méga-pixels par la suite. Un méga-pixel comprend une zone, dite « zone sensible », sensible à une lumière incidente (par exemple la zone sensible 1001 du quadrant B dans la photodiode ME représentée en Fig. 1A) limitée par une frontière (par exemple la frontière 1002 du quadrant B dans la photodiode ME représentée en Fig. 1A). Des paramètres importants caractérisant un méga-pixel sont la surface de la zone sensible et la longueur de la frontière (ou périmètre) limitant la zone sensible. Chaque méga-pixel produit un signal électrique lorsqu'il est touché par un faisceau lumineux. Nous notons $S_A$, $S_B$, $S_C$ et $S_D$ les signaux produits respectivement par les méga-pixels des quadrants *A*, *B*, *C* et *D*. Par ailleurs, une photodiode ME produit deux signaux $\Delta X$ et $\Delta Y$. Les signaux $\Delta X$ et $\Delta Y$ sont représentatifs d'un mouvement dans une scène correspondant au faisceau lumineux reçu par la photodiode ME.

Les valeurs des signaux $\Delta X$ et $\Delta Y$ sont reliées aux valeurs des signaux $S_A$, $S_B$, $S_C$ et $S_D$ par les relations suivantes :

$$\Delta X = \frac{-S_A + S_B - S_C + S_D}{S_A + S_B + S_C + S_D};$$

$$\Delta Y = \frac{S_A + S_B - S_C - S_D}{S_A + S_B + S_C + S_D};$$

Il est courant d'utiliser des photodiodes ME dans un système optronique permettant le suivi d'un objet dans une scène. Les objets suivis sont en général des objets de formes connues, tels que par exemple des pointeurs laser générés par des désignateurs laser. Tant qu'un objet est centré sur la photodiode ME, la photodiode ME produit des signaux $\Delta X$ et $\Delta Y$ nuls. Dès que l'objet s'écarte d'un centre (ou d'un barycentre) de la photodiode ME, au moins un des signaux $\Delta X$ et $\Delta Y$ devient non nul, ce qui permet par la suite de recaler le système optronique sur l'objet visé.

Les signaux représentatifs d'un mouvement $\Delta X$ et $\Delta Y$ dépendent essentiellement de variations (ou gradients) de luminosité sur la frontière de la zone sensible des méga-pixels. Une zone sensible ayant une longueur de frontière importante offre plus de chances de mesurer un gradient de luminosité qu'une zone sensible ayant une longueur de frontière faible. On considère généralement que le gradient de luminosité est proportionnel à la longueur de la frontière de la zone sensible du méga-pixel, alors que chaque signal $S_i$ (ou *i*=*A*, *B*, *C* ou *D* pour une photodiode ME à quatre quadrants) est proportionnel à la surface de la zone sensible du méga-pixel correspondant.

Une augmentation de la longueur de la frontière des zones sensibles des méga-pixels dans une photodiode ME ne permet pas nécessairement d'améliorer la photodiode ME en termes de sensibilité aux mouvements. En effet, l'augmentation de la longueur de la frontière d'une zone sensible entraîne une augmentation de la surface de la zone sensible. Chaque signal $S_i$ intègre tous les faisceaux lumineux reçus par l'ensemble de la surface de la zone sensible du méga-pixel correspondant. Par conséquent, lorsque la surface de la zone sensible est importante, la contribution des gradients de luminosité perçus sur la frontière de la zone sensible dans le signal $S_i$ risque d'être faible par rapport à la contribution de l'ensemble des faisceaux lumineux reçus sur l'ensemble de la surface de la zone sensible. Le signal $S_i$ représente alors essentiellement un signal de bruit d'acquisition, ce qui affecte les signaux $\Delta X$ et $\Delta Y$ en terme d'aptitude à représenter efficacement des mouvements.

L'invention a pour objectif de résoudre les problèmes mentionnés ci-dessus. L'invention vise notamment à proposer un dispositif de détection de mouvement ayant une sensibilité aux mouvements améliorée par rapport à une photodiode ME classique.

A cet effet, selon un premier aspect de la présente invention, la présente invention concerne un dispositif de détection de mouvements comprenant une photodiode multi-éléments, la photodiode multi-éléments comprenant une pluralité de pixels, dits méga-pixel, et pour au moins un méga pixel de la photodiode multi-éléments, dit méga pixel occulté, un masque occultant partiellement une zone sensible dudit méga-pixel occulté, le masque étant constitué d'une pluralité de zones comprenant au moins une zone opaque et au moins une zone transparente, une zone opaque étant apte à empêcher un faisceau lumineux d'atteindre intégralement des portions de la zone sensible du méga-pixel occulté correspondant à ladite zone opaque, une zone transparente étant apte à laisser un faisceau lumineux atteindre une portion de la surface sensible du méga-pixel occulté correspondant à ladite zone transparente, chaque zone opaque possédant au moins une zone voisine transparente de manière à obtenir une alternance de zones opaques et de zones transparentes dans le masque.

L'ajout d'un masque alternant des zones opaques et des zones transparentes permet d'améliorer la sensibilité de la photodiode multi-éléments aux mouvements.

Selon un mode de réalisation, lorsque la photodiode multi-éléments comprend une pluralité de méga pixels occultés, les masques utilisés pour occulter la zone sensible de chaque méga-pixel occulté de la photodiode multi-éléments sont identiques.

L'utilisation de masques identiques permet de simplifier la mise en oeuvre des masques.

Selon un mode de réalisation, lorsque la photodiode multi-éléments comprend une pluralité de méga pixels occultés, des masques différents sont utilisés pour au moins deux méga-pixels occultés de la photodiode multi-éléments.

De cette manière, il est possible de contrôler la sensibilité de certains méga pixels occultés par rapport à d'autres.

Selon un mode de réalisation, chaque masque est un damier comprenant des zones opaques et des zones transparentes de tailles identiques.

Selon un mode de réalisation, chaque masque est un masque anisotrope privilégiant une orientation de gradient de luminosité.

De cette manière, il est possible de privilégier certaines directions de mouvement.

Selon un mode de réalisation, chaque masque anisotrope est constitué d'une alternance de zones opaques et de zones transparentes en forme de bandes perpendiculaires à une orientation de gradient de luminosité à privilégier.

Selon un mode de réalisation, chaque masque est adaptatif et le dispositif de détection de mouvement comprend un dispositif de commande adaptant chaque masque en fonction d'évolutions de forme et de taille d'un objet dont un mouvement est à détecter.

De cette manière la détection de mouvement est améliorée.

Selon un mode de réalisation, chaque masque est adaptatif et le dispositif de détection de mouvement comprend un dispositif de commande apte à adapter chaque masque en fonction d'un contenu d'une scène dans laquelle un mouvement est à détecter, ladite scène correspondant à un faisceau lumineux reçu par le dispositif de détection de mouvement, le contenu de ladite scène étant représenté par des contours d'objets contenus dans ladite scène, des zones de chaque masque correspondant aux contours étant mises en oeuvre par des zones transparentes et des zones de chaque masque ne correspondant pas aux contours étant mises en oeuvre par des zones opaques.

L'utilisation de masques adaptés aux contours des objets permet d'améliorer la détection de mouvement en focalisant la détection de mouvement sur des zones de la scène représentant de forts gradients.

Selon un mode de réalisation, chaque masque est un masque anisotrope adaptatif et le dispositif de détection de mouvement comprend un dispositif de commande apte à adapter chaque masque en fonction d'au moins une caractéristique d'un mouvement obtenue par le dispositif de commande.

Dans certaines scènes, seuls certains types de mouvements sont intéressants. L'adaptation de chaque masque à des caractéristiques du mouvement permet de ne se focaliser que sur certains mouvements intéressants.

Selon un mode de réalisation, la ou au moins une desdites caractéristiques d'un mouvement est représentative d'un mouvement dans une scène dans laquelle un mouvement est à détecter, la ou au moins une desdites caractéristiques ayant été obtenue par un procédé d'estimation de mouvement, ladite scène correspondant à un faisceau lumineux reçu par le dispositif de détection de mouvement.

L'utilisation d'un procédé d'estimation de mouvement permet d'automatiser l'adaptation de chaque masque.

Selon un mode de réalisation, la ou au moins une desdites caractéristiques d'un mouvement est un ensemble de vecteurs de mouvement de blocs de pixels d'une image représentative de ladite scène, le masque anisotrope adaptatif étant divisé en zones, chaque zone correspondant à un desdits blocs de pixels, le masque anisotrope adaptatif étant adapté dans chaque zone de sorte que chaque zone est constituée d'une alternance de zones opaques et de zones transparentes en forme de bandes perpendiculaires à la direction du vecteur de mouvement du bloc de pixels correspondant à la zone.

L'adaptation du masque anisotrope par zone permet de mieux détecter des mouvements locaux dans les images représentatives de la scène.

Selon un mode de réalisation, pour un méga-pixel de la photodiode multi-éléments, le masque est réalisé sur la zone sensible du méga-pixel, ou sous forme d'une lame optique collée sur la zone sensible du méga-pixel, ou sous forme d'une lame optique qui, lorsqu'elle est soumise à un faisceau lumineux, projette une image du masque sur la zone sensible du méga-pixel.

Selon un mode de réalisation, le masque adaptatif est mis en oeuvre par un élément optique de transmission programmable ou par un élément réflectif programmable.

L'utilisation d'un élément optique de transmission programmable ou d'un élément réflectif programmable permet de réaliser des masques adaptatifs.

Selon un deuxième aspect de la présente invention, la présente invention concerne un système optronique comprenant un capteur d'images fonctionnant avec une première fréquence d'acquisition de signal, chaque image obtenue par le capteur d'images étant représentative d'une scène et un dispositif de compensation de mouvement, le système optronique comprenant un dispositif de détection de mouvement selon le premier aspect de l'invention générant des valeurs de signaux représentatifs de mouvements de ladite scène avec une seconde fréquence d'acquisition de signal supérieure à la première fréquence d'acquisition de signal et un dispositif de traitement apte à contrôler le dispositif de compensation de mouvement en fonction desdites valeurs de signaux représentatifs de mouvements.

L'utilisation du dispositif de détection de mouvement selon le premier aspect de l'invention permet d'assurer un contrôle précis du dispositif de compensation de mouvement.

Selon un troisième aspect de la présente invention, la présente invention concerne un procédé de traitement de mouvements de hautes fréquences dans un système optronique comprenant un capteur d'images fonctionnant avec une première fréquence d'acquisition de signal, chaque image obtenue par le capteur d'images étant représentative d'une scène, le procédé comprenant des étapes d'obtention de valeurs de signaux représentatifs d'un mouvement de ladite scène de la part d'un dispositif de détection de mouvement selon le premier aspect de l'invention générant des valeurs de signaux représentatifs de mouvements pouvant affecter l'acquisition d'images par le capteur d'images avec une seconde fréquence d'acquisition de signal, supérieure à la première fréquence d'acquisition de signal, de détermination de valeurs représentatives d'un mouvement d'une image en cours d'acquisition par le capteur d'images à partir desdites valeurs de signaux représentatifs d'un mouvement de ladite scène, ladite détermination comprenant une opération matricielle entre lesdites valeurs de signaux représentatifs d'un mouvement de ladite scène et une matrice de conversion, la matrice de conversion étant obtenue par un procédé d'obtention comprenant une simulation de signaux représentatifs de mouvements obtenus par le dispositif de détection de mouvement, le procédé d'obtention prenant en compte des caractéristiques du dispositif de détection de mouvement, et de transmission des valeurs représentatives d'un mouvement de l'image en cours d'acquisition par le capteur d'images ainsi déterminées à un dispositif de compensation de mouvements afin que ledit dispositif de compensation de mouvements puisse mettre en oeuvre une rétroaction dans le système optronique pour compenser le mouvement de l'image en cours d'acquisition par le capteur d'images.

L'utilisation du dispositif de détection de mouvement selon le premier aspect de l'invention permet d'assurer une compensation précise du mouvement de l'image en cours d'acquisition par le capteur d'images.

Selon un quatrième aspect de la présente invention, la présente invention concerne un produit programme d'ordinateur comportant des instructions pour mettre en oeuvre, par un dispositif, le procédé selon le troisième aspect de l'invention, lorsque ledit programme est exécuté par un processeur dudit dispositif.

Selon un cinquième aspect de la présente invention, la présente invention concerne des moyens de stockage stockant un programme d'ordinateur comportant des instructions pour mettre en oeuvre, par un dispositif, le procédé selon le troisième aspect de l'invention lorsque ledit programme est exécuté par un processeur dudit dispositif.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels:

La Fig. 1A représente schématiquement un exemple de photodiode multi-éléments comportant quatre quadrants carrés,
La Fig. 1B représente schématiquement un exemple de photodiode multi-éléments comportant quatre quadrants en forme de secteurs de disque,
La Fig. 2 illustre schématiquement un premier exemple de dispositif de détection de mouvement selon l'invention,
La Fig. 3 illustre schématiquement un deuxième exemple de dispositif de détection de mouvement selon l'invention,
La Fig. 4 illustre schématiquement un exemple d'architecture matérielle d'un dispositif de traitement apte à traiter les mouvements de hautes fréquences d'un système optronique,
La Fig. 5 représente schématiquement un système optronique comprenant le dispositif de traitement apte à traiter des mouvements de hautes fréquences d'un système optronique,
La Fig. 6 représente schématiquement un exemple de procédé de traitement de mouvements de hautes fréquences d'un système optronique mis en oeuvre par le dispositif de traitement,
La Fig. 7 représente schématiquement un exemple de procédé de détermination d'une matrice de conversion utilisée dans le procédé de traitement de mouvements de hautes fréquences,
La Fig 8 illustre une mise en correspondance de pixels d'une image avec des méga-pixels d'une photodiode multi-éléments, la mise en correspondance étant utilisée dans le procédé de traitement de mouvements de hautes fréquences et prenant en compte une utilisation d'un dispositif de détection de mouvement selon l'invention.

Comme mentionné plus haut, la sensibilité aux mouvements d'une photodiode ME dépend essentiellement de capacités de la photodiode ME à capter des gradients de luminosité. Dans une photodiode ME classique, les gradients de luminosité apparaissent aux frontières de la zone sensible de chaque méga-pixel. Nous avons vu toutefois, qu'une solution intuitive consistant à augmenter la longueur de la frontière des zones sensibles n'était pas satisfaisante. En effet, cette solution augmente le risque d'obtenir de la part de la photodiode ME des signaux correspondant essentiellement à un bruit d'acquisition.

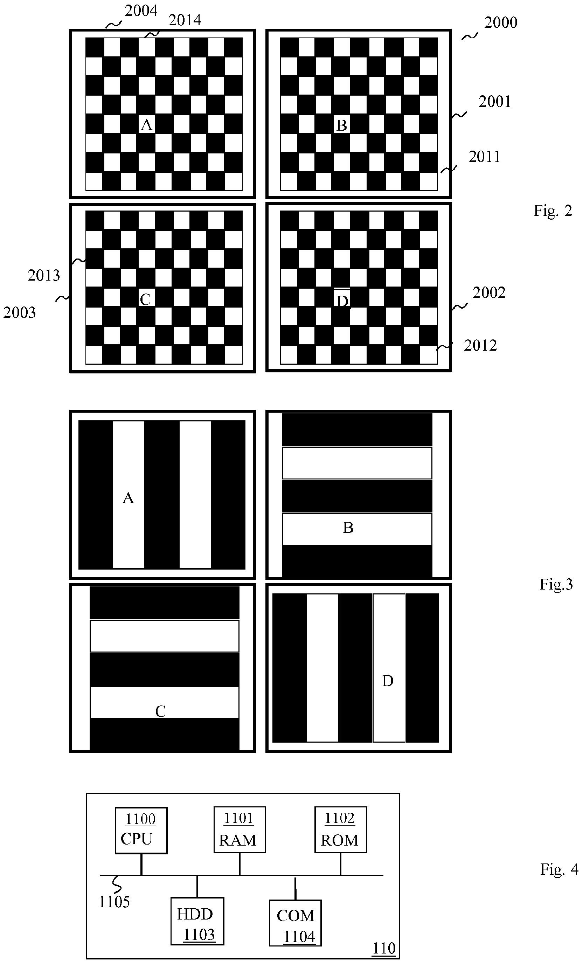

La **Fig. 2** représente schématiquement un premier exemple de dispositif de détection de mouvement selon l'invention. Ce dispositif comprend une photodiode ME 2000 comportant une pluralité de méga-pixels 2001, 2002, 2003 et 2004 et, pour chaque méga-pixel, dit méga-pixel occulté, un masque 2011, 2012, 2013, 2014 apte à occulter partiellement un faisceau lumineux reçu par la zone sensible du mega-pixel. Pour un mega-pixel donné, le masque utilisé est constitué d'une pluralité de zones. Certaines zones de la pluralité de zones que nous appelons « zones opaques » empêchent un faisceau lumineux d'atteindre des portions de la zone sensible du méga-pixel correspondant aux zones opaques et généralement situées en dessous desdites zones opaques. D'autres zones, que nous appelons « zones transparentes », laissent le faisceau lumineux atteindre des portions de la zone sensible du méga-pixel correspondant aux zones transparentes et généralement situées en dessous desdites zones transparentes.

Dans un masque, chaque zone opaque possède au moins une zone voisine transparente de manière à obtenir une alternance de zones opaques et de zones transparentes dans le masque. L'utilisation de tels masques permet d'obtenir sur la zone sensible de chaque méga-pixel de la photodiode ME, une alternance de zones recevant un faisceau lumineux, dites « zones illuminées », et de zones ne recevant pas de faisceau lumineux, dites « zones aveugles ».

Lorsqu'un méga-pixel comportant un tel masque est soumis à un faisceau lumineux, chaque frontière entre une zone illuminée et une zone aveugle est apte à capter un gradient de luminosité. En augmentant le nombre de frontières, on augmente la capacité du méga-pixel à capter des gradients de luminosité. On remarque de plus que l'augmentation du nombre de frontières par l'utilisation d'un tel masque ne se traduit pas par une augmentation de la surface de la zone sensible du méga-pixels, ce qui évite une augmentation de la part du bruit d'acquisition dans les signaux $\Delta X$ et $\Delta Y$ produits par la photodiode ME. L'utilisation de tels masques permet donc d'obtenir un dispositif de détection de mouvement ayant une sensibilité aux mouvements améliorée par rapport à une photodiode classique.

Dans l'exemple de la Fig. 2, un même masque occulte partiellement la zone sensible de chaque méga-pixel. Le masque utilisé est un damier alternant régulièrement des zones opaques et des zones transparentes de tailles identiques.

Dans un mode de réalisation, chaque masque est réalisé directement sur la zone sensible des méga-pixels.

La **Fig. 3** représente schématiquement un deuxième exemple de dispositif de détection de mouvement selon l'invention. Dans ce mode de réalisation, on utilise des masques anisotropes. Un masque anisotrope permet de privilégier certaines orientations de gradient de luminosité. Les zones opaques et les zones transparentes d'un masque anisotrope sont des bandes pouvant être verticales, horizontales ou obliques suivant l'orientation d'un gradient de luminosité que l'on souhaite privilégier.

Dans l'exemple de la Fig. 3, au moins deux méga-pixels comportent des masques différents. Les masques anisotropes occultant partiellement la zone sensible des méga-pixels *A* et *D* sont constitués de bandes verticales privilégiant une détection de gradients de luminosité horizontaux et donc une détection de mouvements horizontaux. Les masques anisotropes occultant partiellement les méga-pixels *B* et *C* sont constitués de bandes horizontales privilégiant une détection de gradients de luminosité verticaux et donc une détection de mouvements verticaux.

Dans un mode de réalisation, chaque masque est réalisé sous forme d'une lame optique et collée sur la zone sensible de chaque méga-pixel.

Dans un mode de réalisation, chaque masque est réalisé sous forme d'une lame optique qui lorsqu'elle est soumise à un faisceau lumineux projette une image du masque sur la zone sensible de chaque méga-pixel.

Dans un mode de réalisation, les zones opaques sont aptes à atténuer une intensité lumineuse d'un faisceau lumineux, sans le bloquer intégralement. On choisit alors une atténuation suffisante pour que les gradients de luminosité en frontière de zones illuminées et de zones aveugles soient détectables par les méga-pixels.

Dans un mode de réalisation, au moins un méga-pixel d'une photodiode ME comportant une pluralité de méga-pixels est associé à un masque.

Dans une mise en oeuvre particulière, un dispositif de détection de mouvement selon l'invention est utilisé dans un système optronique pour détecter des mouvements de hautes fréquences.

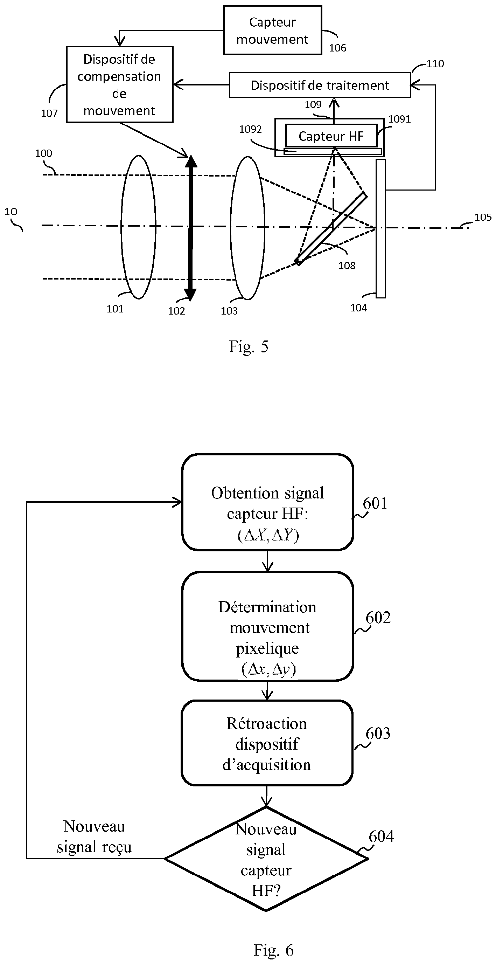

La **Fig. 5** représente schématiquement un système optronique 10, tel que par exemple un appareil photo, constitué d'un élément optique comprenant par exemple deux groupes de lentilles, tels que les groupes de lentilles 101 et 103, un élément mobile 102 généralement mis en oeuvre par une lentille flottante, un capteur d'images 104 tel qu'un capteur CCD (dispositif à charge couplée : « Charge-Coupled Device » en terminologie anglo-saxonne) ou CMOS (semi-conducteur métal-oxyde complémentaire : «Complementary Metal-Oxide-Semiconductor » en terminologie anglo-saxonne). Les groupes de lentilles 101 et 103, l'élément mobile 102 et le capteur d'images 104 sont perpendiculaires à un axe optique 105. Les groupes de lentilles 101 et 103 et l'élément mobile 102 font converger un faisceau lumineux 100 vers le capteur d'images 104. Un capteur de mouvement 106, mis en oeuvre par exemple par un gyromètre, détermine des mouvements de basses et de moyennes fréquences du système optronique et transmet ces informations à un dispositif de compensation de mouvement 107 modifiant la position de l'élément mobile 102 de manière à compenser les mouvements du système optronique 10. Le dispositif de compensation de mouvement 107 est mis en oeuvre par exemple par des moteurs ou par des électroaimants. Le capteur d'images 104 produit des images à partir du faisceau lumineux 100 reçu. Les images sont produites à une fréquence d'acquisition de signal (ou fréquence d'acquisition d'images) de l'ordre de quelques dizaines de Hertz et sont transmises en direction d'un afficheur ou d'une mémoire.

Le système optronique 10 comporte de plus un dispositif 108 permettant de rediriger une partie du faisceau lumineux 100 vers un dispositif de détection de mouvement 109 selon l'invention. Dans le système optronique 10, le dispositif de détection de mouvement 109 fait office de capteur de mouvement haute fréquence. Le dispositif 108 peut être par exemple un dispositif semi réfléchissant. Le dispositif de détection de mouvement 109 comprend une photodiode ME 1091 et un ensemble de masques 1092 placé devant la photodiode ME 1091. L'ensemble de masques 1092 comprend une pluralité de masques, chaque méga-pixel de la photodiode ME 1091 étant associé à un des masques de l'ensemble de masques 1092. Le dispositif de détection de mouvement 109 est apte à fournir des valeurs représentatives d'un mouvement avec une fréquence d'acquisition de signal de l'ordre de quelques KHz correspondant à la fréquence d'acquisition de signal de la photodiode ME 1091.

Dans le système optronique 10, le faisceau lumineux 100 est transmis simultanément en direction du capteur d'images 104 et du dispositif de détection de mouvement 109, chaque capteur recevant une partie du faisceau lumineux 100. De cette manière, des mouvements de hautes fréquences pouvant affecter l'acquisition d'images par le capteur d'images 104 sont détectés et des valeurs représentatives de ces mouvements peuvent être mesurées par le dispositif de détection de mouvement 109 avec une fréquence d'acquisition de signal de l'ordre de quelques KHz.

Dans le système optronique 10, les valeurs représentatives du mouvement sont transmises à un dispositif de traitement 110 déterminant des valeurs de mouvement utilisables par le dispositif de compensation de mouvement 107. Ces valeurs de mouvement utilisables par le dispositif de compensation de mouvement 107 sont représentatives de mouvements dans les images acquises par le capteur d'images 104 et sont mesurées en nombres de pixels. Nous appelons par la suite ces mouvements « mouvements pixeliques ». Il existe une relation directe entre les mouvements pixeliques et les mouvements du système optronique. Les mouvements du système optronique considérés ici sont des mouvements angulaires. Un système optique possède une distance focale f connue par construction. La distance focale f est un paramètre permettant de faire le lien entre un mouvement pixelique et le mouvement angulaire.

Les valeurs représentatives des mouvements pixeliques déterminées par le dispositif de traitement 110 peuvent donc être utilisées directement par le dispositif de compensation de mouvement 107 pour compenser les mouvements du système optronique. De cette manière, le dispositif de traitement 110 contrôle le dispositif de compensation de mouvement 107 en se basant sur les valeurs des signaux représentatifs de mouvement $\Delta X$ et $\Delta Y$ produits par la photodiode 1091 du dispositif de détection de mouvement 109.

Lorsque les valeurs représentatives des mouvements pixeliques sont exprimées sous la forme d'une valeur de mouvement horizontal $\Delta x$ et d'une valeur de mouvement vertical $\Delta y$, il existe une relation entre les signaux $\Delta X$ et $\Delta Y$ produits par la photodiode ME 1091 et les valeurs représentatives des mouvements pixeliques :

$$\begin{pmatrix} \Delta X \\ \Delta Y \end{pmatrix} = M . \begin{pmatrix} \Delta x \\ \Delta y \end{pmatrix}$$

où $M$ est une matrice de conversion carrée 2x2 dépendant d'un contenu d'une scène visée par le système optronique.

Lorsque les valeurs représentatives de mouvements pixeliques sont déterminées par le dispositif de traitement 110, elles sont transmises au dispositif de compensation de mouvement 107 pour qu'il puisse compenser ces mouvements pixeliques. La fréquence de transmission des valeurs représentatives des mouvements pixeliques au dispositif de compensation de mouvement 107 peut par exemple être égale à la fréquence d'acquisition de signal de la photodiode ME 1091. De cette manière, le dispositif de compensation de mouvement 107 peut compenser des mouvements de hautes fréquences.

La **Fig. 6** représente schématiquement un exemple de procédé de traitement des mouvements de hautes fréquences du système optronique 10 mis en oeuvre par le dispositif de traitement 110. Ce procédé comprend l'obtention par le dispositif de traitement 110 de valeurs de signaux représentatifs de mouvements de la part de la photodiode ME 1091 du dispositif de détection de mouvement 109. Comme nous l'avons vu plus haut, un mouvement pixelique est représentatif d'un mouvement du système optronique. Dans une étape 601, le dispositif de traitement 110 obtient des valeurs des signaux $\Delta X$ et $\Delta Y$ de la photodiode ME 1091.

Lors d'une étape 602, le dispositif de traitement 110 détermine les valeurs représentatives des mouvements pixeliques de la manière suivante :

$$\begin{pmatrix} \Delta x \\ \Delta y \end{pmatrix} = M^{-1} \cdot \begin{pmatrix} \Delta X \\ \Delta Y \end{pmatrix}$$

où $M^{-1}$ est l'inverse de la matrice de conversion $M$.

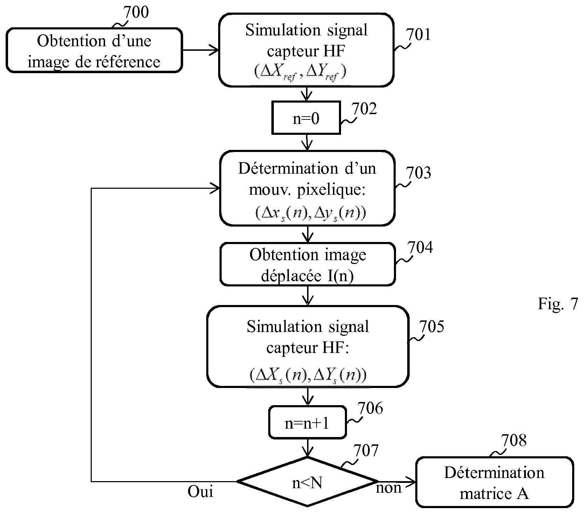

La matrice de conversion $M$ est supposée connue par le dispositif de traitement 110 lors de l'étape 602. Nous décrivons par la suite en relation avec la Fig. 7 un procédé de détermination de la matrice de conversion $M$ mis en oeuvre périodiquement par le dispositif de traitement 110.

Dans une étape 603, le dispositif de traitement 110 transmet les valeurs représentatives des mouvements pixeliques ainsi calculées au dispositif de compensation de mouvement 107 afin qu'il puisse mettre en oeuvre une rétroaction dans le système optronique pour compenser le mouvement pixelique calculé. Dans ce mode de réalisation, la transmission des valeurs représentatives des mouvements pixeliques suit la fréquence d'acquisition de signal de la photodiode ME 1091. La rétroaction peut donc être mise en oeuvre à la fréquence d'acquisition de signal de la photodiode. On obtient donc une rétroaction haute fréquence.

Le dispositif de traitement 110 se met ensuite en attente de réception de nouvelles valeurs des signaux $\Delta X$ et $\Delta Y$ de la part de la photodiode ME 1091 dans une étape 604. Lorsque de nouvelles valeurs des signaux $\Delta X$ et $\Delta Y$ sont reçues, le dispositif de traitement met de nouveau en oeuvre l'étape 601.

Le procédé de détermination des valeurs représentatives des mouvements pixeliques décrit en relation avec la Fig. 6 nécessite la connaissance de la matrice de conversion $M$. La matrice de conversion $M$ évolue dans le temps et dépend de la scène sur laquelle est focalisé le dispositif de détection de mouvement 109. Il est alors nécessaire de déterminer la matrice de conversion $M$ et de remettre à jour périodiquement cette matrice pour prendre en compte des changements dans la scène sur laquelle est focalisé le système optronique 10.

La **Fig. 7** illustre un exemple de procédé de détermination de la matrice de conversion $M$ mis en oeuvre périodiquement par le dispositif de traitement 110. Le procédé de détermination de la matrice de conversion M prend en compte des caractéristiques du dispositif de détection de mouvement 109 et notamment la présence de l'ensemble de masques 1092 devant la photodiode 1091. Dans un mode de réalisation, le procédé de détermination de la matrice de conversion $M$ est mis en oeuvre par le dispositif de traitement 110 lors de chaque acquisition d'une image par le capteur d'images 104. Une image acquise par le capteur d'images 104 est appelée « image originale » par la suite.

Dans une étape 700, une image originale acquise par le capteur d'images 104 est obtenue par le dispositif de traitement 110. Dans un mode de réalisation, le dispositif de traitement 110 utilise cette image originale comme image de référence lors de la détermination de la matrice de conversion $M$.

Dans une étape 701, le dispositif de traitement 110 simule les signaux $\Delta X_{ref}$ et $\Delta Y_{ref}$ que fournirait la photodiode ME 1091 si elle était soumise à un faisceau lumineux correspondant à l'image de référence selon un procédé de simulation que nous expliquons par la suite.

Dans une étape 702, une variable $n$ est initialisée à zéro.

Lors des étapes 703 à 707, le dispositif de traitement 110 applique des mouvements de valeurs prédéterminées à l'image de référence pour obtenir un ensemble d'images déplacées et, pour chaque image déplacée, simule les signaux $\Delta X$ et $\Delta Y$ que fournirait la photodiode ME 1091 si elle était soumise à un faisceau lumineux correspondant à l'image déplacée. Ces étapes sont détaillées par la suite.

Lors de l'étape 703, un mouvement pixelique d'une valeur prédéterminée comprenant une valeur de mouvement horizontal $\Delta x_s(n)$ et une valeur de mouvement vertical $\Delta y_s(n)$ est obtenu par le dispositif de traitement 110. Cette valeur de mouvement prédéterminée est obtenue par exemple d'une liste de valeurs de mouvements prédéterminées stockée dans une mémoire du dispositif de traitement 110.

Dans une étape 704, une image déplacée I(n) est créée en déplaçant les pixels de l'image de référence de la valeur du mouvement pixelique $(\Delta x_s(n) \, \Delta y_s(n))$.

Dans une étape 705, le dispositif de traitement met en oeuvre un procédé de simulation des valeurs des signaux $\Delta X_s(n)$ et $\Delta Y_s(n)$ que fournirait la photodiode ME si elle était soumise à un faisceau lumineux correspondant à l'image déplacée I(n). Ce procédé de simulation est expliqué par la suite. Lors de cette étape le dispositif de traitement 110 détermine les valeurs des signaux $S_A$, $S_B$, $S_C$ et $S_D$.

Les valeurs des signaux $\Delta X_s(n)$ et $\Delta Y_s(n)$ sont ensuite calculées de la manière suivante :

$$\Delta X_s(n) = \frac{-S_A + S_B - S_C + S_D}{S_A + S_B + S_C + S_D} - \Delta X_{ref};$$

$$\Delta Y_s(n) = \frac{S_A + S_B - S_C - S_D}{S_A + S_B + S_C + S_D} - \Delta Y_{ref} ;$$

Lors d'une étape 706, la variable $n$ est incrémentée d'une unité. Lors d'une étape 707, la variable $n$ est comparée à une constante $N$ que nous expliquons par la suite. Lorsque la variable $n$ est inférieure à $N$, le dispositif de traitement 110 crée une nouvelle image déplacée I(n) en retournant à l'étape 703. Une valeur de mouvement pixelique prédéterminée différente de toute autre valeur de mouvement pixelique prédéterminée déjà utilisée pour des images déplacées I(n) créées précédemment est alors obtenue par le dispositif de traitement 110.

Si la variable $n$ est égale à la constante $N$, l'étape 707 est suivie d'une étape 708 au cours de laquelle la matrice de conversion $M$ est déterminée.

La constante $N$ fixe le nombre d'images I(n) nécessaire au calcul de la matrice de conversion $M$. La matrice de conversion $M$ étant une matrice 2x2, elle comporte quatre coefficients. Les coefficients de la matrice de conversion $M$ forment un ensemble de quatre inconnues à déterminer. Pour chaque image déplacée I(n), la relation suivante s'applique:

$$\begin{pmatrix} \Delta X_s(n) \\ \Delta Y_s(n) \end{pmatrix} = M . \begin{pmatrix} \Delta x_s(n) \\ \Delta y_s(n) \end{pmatrix} = \begin{pmatrix} a_{11} & a_{21} \\ a_{12} & a_{22} \end{pmatrix} . \begin{pmatrix} \Delta x_s(n) \\ \Delta y_s(n) \end{pmatrix}$$

où $a_{ij}$ représente des coefficients de la matrice $M$. Cette relation fournit donc deux équations pour chaque image I(n). Connaissant pour chaque image I(n) les valeurs des signaux $\Delta X_s(n)$ et $\Delta Y_s(n)$ et les valeurs du mouvement pixelique correspondant $(\Delta x_s(n)\ \Delta y_s(n))$, il est nécessaire et suffisant d'avoir deux images I(n) pour pouvoir calculer les quatre coefficients $a_{ij}$ de la matrice de conversion $M$. En théorie, il suffit donc de fixer la constante $N$ à la valeur deux pour déterminer la matrice de conversion $M$. Toutefois, pour éviter d'obtenir des valeurs de coefficient $a_{ij}$ de la matrice de conversion $M$ bruitées, il est préférable de fixer la constante $N$ à une valeur supérieure à deux.

On obtient alors un système de $2N$ ($N>2$) équations à quatre inconnues pouvant être résolu de manière classique par une régression linéaire au cours de l'étape 708.

Dès sa détermination, la matrice de conversion $M$ est utilisée par le dispositif de traitement 110 lors de l'étape de détermination de mouvements pixeliques 602.

Comme nous l'avons vu plus haut, le procédé de détermination de la matrice $M$ comprend lors des étapes 701 et 705 un procédé de simulation des valeurs des signaux $\Delta X_{ref}$ et $\Delta Y_{ref}$ et des signaux $\Delta X_s(n)$ et $\Delta Y_s(n)$ que fournirait la photodiode ME 1091 si elle était soumise à un faisceau lumineux correspondant respectivement à l'image de référence ou à une image déplacée I(n). Soit une image $\hat{I}$ pouvant être une image de référence ou une image déplacée I(n). Au cours de la mise en oeuvre du procédé de simulation, le dispositif de traitement 110 met en correspondance chaque méga-pixel de la photodiode ME avec un ensemble de pixels de l'image $\hat{I}$ en prenant en compte la présence de l'ensemble de masques 1092. Pour chaque méga-pixel, une somme des valeurs des pixels de l'image $\hat{I}$ non masqués par le masque correspondant de l'ensemble de masques 1092 est calculée. La valeur d'un signal $S_i$ ($i \in \{A,B,C,D\}$) est alors égale à la somme des valeurs des pixels non masqués de l'image $\hat{I}$ calculée sur le méga-pixel correspondant.

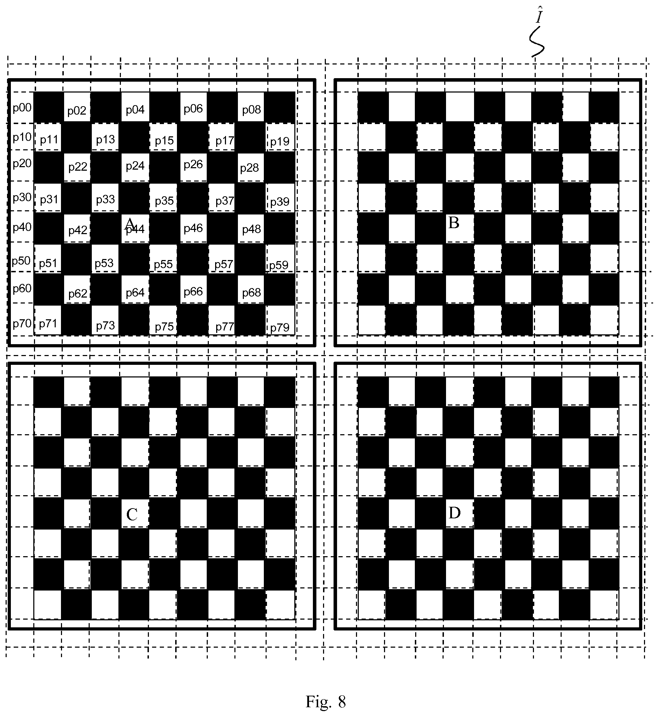

La **Fig. 8** représente un exemple de mise en correspondance de pixels d'une image $\hat{I}$ comportant quatre cent quarante pixels avec la photodiode quatre quadrants représentée schématiquement en Fig. 1A sur laquelle est appliqué l'ensemble de masques représenté schématiquement en Fig. 2. Dans cet exemple, la valeur du signal $S_A$ est calculée comme une somme des valeurs des pixels $p_{ij}$ ($i \in [0,7]$, $j \in [0,9]$) correspondant au cadran A telle que seules les valeurs des pixels $p_{ij}$ pour lesquels la variable $j$=0 ou les valeurs des pixels $p_{ij}$ pour lesquels la parité de la variable $i$ est égale à la parité de la variable $j$ (i.e. les variables $i$ et $j$ sont toutes les deux paires ou toutes les deux impaires) sont sommées.

Les masques décrits en relation avec les Figs. 2 et 3 sont supposés statiques. Dans un mode de réalisation, chaque masque peut être adaptatif par exemple en fonction d'évolutions de forme et de taille d'un objet dont on souhaite détecter le mouvement. Par exemple, lorsque l'objet est petit, la sensibilité d'une photodiode ME aux mouvements d'un tel objet peut être améliorée si le masque placé devant chaque méga-pixel comporte un nombre de zones opaques et des zones transparentes important et si ces zones sont de petite taille. Les mouvements d'un objet de grande taille peuvent par contre être détectés efficacement avec un masque comportant un nombre de zones opaques et des zones transparentes faibles et des zones de grande taille. Ce type de masque adaptatif adapté à la taille d'un objet peut par exemple être utilisé dans le dispositif de détection de mouvement 109 du système optronique 10. Dans un mode de réalisation, la taille d'un objet dont on souhaite suivre le mouvement est estimée par le dispositif de traitement 110 à partir des images acquises par le capteur d'images 104. Lorsque par rapport à une image précédente, la taille de l'objet augmente, le dispositif de traitement 110 envoie des paramètres (ou commandes) d'adaptation au dispositif de détection de mouvement 109 de manière à diminuer le nombre de zones opaques et de zones transparentes et à augmenter la taille des zones dans les masques de l'ensemble de masques 1092. Lorsque par rapport à une image précédente, la taille de l'objet diminue, le dispositif de traitement 110 envoie des paramètres (ou commandes) d'adaptation au dispositif de détection de mouvement 109 de manière augmenter le nombre de zones opaques et de zones transparentes et à diminuer la taille des zones dans les masques de l'ensemble de masques 1092. Le dispositif de traitement 110 fait donc office de dispositif de commande automatique pour l'ensemble de masques adaptatifs 1092.

Une adaptation plus fine des masques de l'ensemble de masques 1092 au contenu d'une image correspondant à un faisceau lumineux reçu par le dispositif de détection de mouvement 109 peut aussi être envisagée. L'utilisation d'un masque permet de créer artificiellement des gradients dans le faisceau lumineux capté par chaque méga-pixel d'une photodiode ME. Le faisceau lumineux reçu par une photodiode ME correspond à une scène. La détection de mouvements est facilitée lorsque ladite scène comporte elle-même des forts gradients. Les zones uniformes de la scène sont, quant à elle, difficilement exploitables pour de la détection de mouvement et ont plutôt tendance à bruiter la détection de mouvement. Dans une scène, les zones à forts gradients correspondent à des contours d'objets compris dans la scène. On peut donc adapter les masques de l'ensemble de masques 1092 de manière à ne transmettre à la photodiode ME 1091 que des portions du faisceau lumineux correspondant aux contours des objets.

Dans un mode de réalisation, un dispositif de détection de mouvement 109 comportant un ensemble de masques 1092 adaptatifs, chaque masque étant adapté au contenu des images reçues par le capteur d'images 104, est utilisé dans le système optronique 10. Lors de chaque acquisition d'une image par le capteur d'images 104, une détection de contours est mise en oeuvre par le dispositif de traitement 110 sur l'image captée par le capteur d'images 104. La détection de contours peut par exemple être basée sur un filtrage passe haut de l'image captée par le capteur 104.

Par la suite, les masques de l'ensemble de masques 1092 sont adaptés aux contours détectés, sous le contrôle du dispositif de traitement 110. Par exemple, chaque masque comportera des zones transparentes dans des zones correspondant aux contours détectés et des zones opaques dans des zones ne correspondant pas à des contours.

Dans un mode de réalisation, les masques de l'ensemble de masques 1092 sont adaptés à au moins une caractéristique d'un mouvement dans la scène correspondant au signal lumineux reçu par le dispositif de détection de mouvement 109. Des masques anisotropes adaptatifs sont utilisés pour privilégier certaines directions de mouvements. Dans une mise en oeuvre de ce mode de réalisation, les directions de mouvement privilégiées peuvent être déterminées par un opérateur utilisant un dispositif de commande pour paramétrer les masques de l'ensemble de masques. L'opérateur détermine une direction de mouvement privilégiée pour chaque masque. Chaque masque est alors constitué d'une succession de bandes transparentes et opaques perpendiculaires à la direction de mouvement privilégiée.

Dans un mode de réalisation, les directions de mouvement privilégiées sont déterminées automatiquement en utilisant un procédé d'estimation de mouvement de type mise en correspondance de blocs (« block matching » en terminologie anglo-saxonne). Lors de chaque acquisition d'une image par le capteur d'images 104, le dispositif de traitement 110 met en oeuvre une estimation de mouvement entre la dernière image acquise par le capteur d'images 104 et l'image qui la précède. L'estimation de mouvement se fait par blocs de pixels en prenant par exemple des blocs de taille 32x32. D'autres tailles de blocs plus grandes ou plus petites pourraient toutefois être utilisées. Suite à l'estimation de mouvement, chaque bloc 32x32 de la dernière image acquise par le capteur d'images 104 est associé à une information représentative d'un mouvement telle qu'un vecteur de mouvement. Chaque masque de l'ensemble de masques 1092 est alors divisé en zones, chaque zone étant associée à un bloc 32x32 de la dernière image acquise par le capteur d'images 104. Dans chaque zone, chaque masque de l'ensemble de masques 1092 est constitué d'une succession de bandes transparentes et de bandes opaques perpendiculaires au vecteur de mouvement associé au bloc 32x32 correspondant à la zone. L'adaptation des masques de l'ensemble de masques 1092 se fait là encore sous le contrôle du dispositif de traitement 110.

On remarque que chaque masque de l'ensemble de masques 1092 adaptatif peut être mis en oeuvre en plaçant devant chaque méga-pixel de la photodiode ME 1091 un élément optique de transmission programmable localement, tel qu'un écran à cristaux liquides. Alternativement, chaque masque de l'ensemble de masques 1092 peut être mis en oeuvre par un élément réflectif programmable tel qu'une matrice de micro-miroirs de type DLP (traitement de lumière numérique : « Digital Light Processing » en terminologie anglo-saxonne). Les deux éléments programmables aptes à mettre en oeuvre les masques de l'ensemble de masques 1092 peuvent, comme nous l'avons vu plus haut, être paramétrés par un dispositif de commande manipulé par un opérateur ou paramétré par le dispositif de traitement 110 qui transmet des paramètres (ou commandes) d'adaptation aux masques. Le dispositif de traitement 110 fait alors office de dispositif de commande automatique des masques de l'ensemble de masques 1092.

La **Fig. 4** illustre schématiquement un exemple d'architecture matérielle du dispositif de traitement 110. Le dispositif de traitement 110 comporte, reliés par un bus de communication 1105 : un processeur ou CPU (« Central Processing Unit» en anglais) 1100; une mémoire vive RAM (« Random Access Memory » en anglais) 1101; une mémoire morte ROM (« Read Only Memory » en anglais) 1102; une unité de stockage 1103 ou un lecteur de support de stockage, tel qu'un lecteur de cartes SD (« Secure Digital » en anglais) ou de clés USB (« Universal Serial Bus » en anglais) ou un disque dur HDD (« Hard Disk Drive » en anglais); au moins une interface 1104 permettant d'échanger des données avec d'autres dispositifs. L'interface 1104 permet par exemple au dispositif de traitement 110 de recevoir des valeurs de signaux Δ*X* et Δ*Y* de la part de la photodiode ME 1091 et des images de la part du capteur d'image 104 et de transmettre des paramètres d'adaptation aux masques de l'ensemble de masques 1092 lorsque lesdits masques sont adaptatifs.

Le processeur 1100 est capable d'exécuter des instructions chargées dans la RAM 1101 à partir de la ROM 1102, d'une mémoire externe (non représentée), d'un support de stockage, ou d'un réseau de communication. Lorsque le dispositif de traitement 110 est mis sous tension, le processeur 1100 est capable de lire de la RAM 1101 des instructions et de les exécuter. Ces instructions forment un programme d'ordinateur causant la mise en oeuvre, par le processeur 1100, de tout ou partie des algorithmes et étapes décrits en relation avec le dispositif de traitement 110 et les Figs. 6 et 7.

Tout ou partie des algorithmes et étapes décrits précédemment peut ainsi être implémenté sous forme logicielle par exécution d'un ensemble d'instructions par une machine programmable, tel qu'un DSP (« Digital Signal Processor » en anglais) ou un microcontrôleur, ou être implémenté sous forme matérielle par une machine ou un composant dédié, tel qu'un FPGA (« Field-Programmable Gate Array » en anglais) ou un ASIC (« Application-Specific Integrated Circuit » en anglais).

**Revendications**

1.  Dispositif de détection de mouvement, comprenant :

    une photodiode multi-éléments (2000), la photodiode multi-éléments comprenant une pluralité de pixels (2001, 2002, 2003, 2004), dits méga-pixels, et
    pour au moins un méga pixel de la photodiode multi-éléments, dit méga pixel occulté, un masque (2011, 2012, 2013, 2014) occultant partiellement une zone sensible dudit méga-pixel occulté, le masque étant constitué d'une pluralité de zones comprenant au moins une zone opaque et au moins une zone transparente, une zone opaque étant apte à empêcher un faisceau lumineux d'atteindre intégralement des portions de la zone sensible du méga-pixel occulté correspondant à ladite zone opaque, une zone transparente étant apte à laisser un faisceau lumineux atteindre une portion de la surface sensible du méga-pixel occulté correspondant à ladite zone transparente, chaque zone opaque possédant au moins une zone voisine transparente de manière à obtenir une alternance de zones opaques et de zones transparentes dans le masque.

2.  Dispositif de détection de mouvement selon la revendication 1, dans lequel, lorsque la photodiode multi-éléments comprend une pluralité de méga pixels occultés, les masques utilisés pour occulter la zone sensible de chaque méga-pixel occulté de la photodiode multi-éléments sont identiques.

3.  Dispositif de détection de mouvement selon la revendication 1, dans lequel, lorsque la photodiode multi-éléments comprend une pluralité de méga pixels occultés, des masques différents sont utilisés pour au moins deux méga-pixels occultés de la photodiode multi-éléments.

4.  Dispositif de détection de mouvement selon la revendication 1, 2 ou 3, dans lequel chaque masque est un damier comprenant des zones opaques et des zones transparentes de tailles identiques.

5.  Dispositif de détection de mouvement selon la revendication 1, 2 ou 3, dans lequel chaque masque est un masque anisotrope privilégiant une orientation de gradient de luminosité.

6.  Dispositif de détection de mouvement selon la revendication 5, dans lequel chaque masque anisotrope est constitué d'une alternance de zones opaques et de zones transparentes en forme de bandes perpendiculaires à une orientation de gradient de luminosité à privilégier.

7.  Dispositif de détection de mouvement selon la revendication 1, dans lequel chaque masque est adaptatif et en ce que le dispositif de détection de mouvement comprend un dispositif de commande (110) adaptant chaque masque en fonction d'évolutions de forme et de taille d'un objet dont un mouvement est à détecter.

8.  Dispositif de détection de mouvement selon la revendication 1, dans lequel chaque masque est adaptatif et le dispositif de détection de mouvement comprend un dispositif de commande (110) apte à adapter chaque masque en fonction d'un contenu d'une scène dans laquelle un mouvement est à détecter, ladite scène correspondant à un faisceau lumineux reçu par le dispositif de détection de mouvement, le contenu de ladite scène étant représenté par des contours d'objets contenus dans ladite scène, des zones de chaque masque correspondant aux contours étant mises en oeuvre par des zones transparentes et des zones de chaque masque ne correspondant pas aux contours étant mises en oeuvre par des zones opaques.

9. Dispositif de détection de mouvement selon la revendication 1, dans lequel chaque masque est un masque anisotrope adaptatif et le dispositif de détection de mouvement comprend un dispositif de commande (110) apte à adapter chaque masque en fonction d'au moins une caractéristique d'un mouvement obtenue par le dispositif de commande.

10. Dispositif selon la revendication 9, dans lequel la ou au moins une desdites caractéristiques d'un mouvement est représentative d'un mouvement dans une scène dans laquelle un mouvement est à détecter, la ou au moins une desdites caractéristiques ayant été obtenue par un procédé d'estimation de mouvement, ladite scène correspondant à un faisceau lumineux reçu par le dispositif de détection de mouvement.

11. Dispositif selon la revendication 10, dans lequel la ou au moins une desdites caractéristiques d'un mouvement est un ensemble de vecteurs de mouvement de blocs de pixels d'une image représentative de ladite scène, le masque anisotrope adaptatif étant divisé en zones, chaque zone correspondant à un desdits blocs de pixels, le masque anisotrope adaptatif étant adapté dans chaque zone de sorte que chaque zone est constituée d'une alternance de zones opaques et de zones transparentes en forme de bandes perpendiculaires à la direction du vecteur de mouvement du bloc de pixels correspondant à la zone.

12. Dispositif selon l'une quelconque des revendications 1 à 6, dans lequel, pour un méga-pixel de la photodiode multi-éléments, le masque est réalisé sur la zone sensible du méga-pixel, ou sous forme d'une lame optique collée sur la zone sensible du méga-pixel, ou sous forme d'une lame optique qui, lorsqu'elle est soumise à un faisceau lumineux, projette une image du masque sur la zone sensible du méga-pixel.

13. Dispositif selon l'une quelconque des revendications 7 à 11, dans lequel le masque adaptatif est mis en oeuvre par un élément optique de transmission programmable ou par un élément réflectif programmable.

14. Système optronique comprenant un capteur d'images (104) fonctionnant avec une première fréquence d'acquisition de signal, chaque image obtenue par le capteur d'images étant représentative d'une scène et un dispositif (107) de compensation de mouvement, dans lequel le système optronique comprend un dispositif de détection de mouvement (109) selon l'une quelconque des revendications 1 à 13 générant des valeurs de signaux représentatifs de mouvements de ladite scène avec une seconde fréquence d'acquisition de signal supérieure à la première fréquence d'acquisition de signal et un dispositif de traitement (110) apte à contrôler le dispositif de compensation de mouvement en fonction desdites valeurs de signaux représentatifs de mouvements.

15. Procédé de traitement de mouvements de hautes fréquences dans un système optronique comprenant un capteur d'images (104) fonctionnant avec une première fréquence d'acquisition de signal, chaque image obtenue par le capteur d'images étant représentative d'une scène,
dans lequel le procédé comprend les étapes suivantes de:

- obtention (601) de valeurs de signaux représentatifs d'un mouvement de ladite scène de la part d'un dispositif de détection de mouvement (109) selon l'une quelconque des revendications 1 à 13 générant des valeurs de signaux représentatifs de mouvements pouvant affecter l'acquisition d'images par le capteur d'images (104) avec une seconde fréquence d'acquisition de signal, supérieure à la première fréquence d'acquisition de signal,
- détermination (602) de valeurs représentatives d'un mouvement d'une image en cours d'acquisition par le capteur d'images à partir desdites valeurs de signaux représentatifs d'un mouvement de ladite scène, ladite détermination comprenant une opération matricielle entre lesdites valeurs de signaux représentatifs d'un mouvement de ladite scène et une matrice de conversion, la matrice de conversion étant obtenue par un procédé d'obtention comprenant une simulation (701, 705) de signaux représentatifs de mouvements obtenus par le dispositif de détection de mouvement, le procédé d'obtention prenant en compte des caractéristiques du dispositif de détection de mouvement,
- transmission (603) des valeurs représentatives d'un mouvement de l'image en cours d'acquisition par le capteur d'images ainsi déterminées à un dispositif de compensation de mouvements (107) afin que ledit dispositif de compensation de mouvements puisse mettre en oeuvre une rétroaction dans le système optronique pour compenser le mouvement de l'image en cours d'acquisition par le capteur d'images.

16. Produit programme d'ordinateur, comprenant des instructions pour mettre en oeuvre, par un dispositif, le procédé selon la revendication 15, lorsque ledit programme est exécuté par un processeur dudit dispositif.

**17.** Moyens de stockage stockant un programme d'ordinateur comportant des instructions pour mettre en oeuvre, par un dispositif, le procédé selon la revendication 15 lorsque ledit programme est exécuté par un processeur dudit dispositif.

**Patentansprüche**

**1.** Bewegungserfassungsvorrichtung, umfassend:

eine Mehrelement-Fotodiode (2000), wobei die Mehrelement-Fotodiode eine Vielzahl von Pixeln (2001, 2002, 2003, 2004), sogenannten Megapixeln umfassen, und
für wenigstens ein Megapixel der Mehrelement-Fotodiode, das sogenannte abgedeckte Megapixel, eine Maske (2011, 2012, 2013, 2014) teilweise einen empfindlichen Bereich des abgedeckten Megapixels abdeckt, wobei die Maske aus einer Vielzahl von Bereichen umfassend wenigstens einen opaken Bereich und wenigstens einen transparenten Bereich besteht, wobei ein opaker Bereich zum Verhindern, dass ein Lichtbündel vollständig Teile des empfindlichen Bereiche des abgedeckten Megapixels entsprechend dem opaken Bereich erreicht, ausgebildet ist, wobei ein transparenter Bereich zum Zulassen, dass ein Lichtbündel einen Teil der empfindlichen Oberfläche des abgedeckten Megapixels entsprechend dem transparenten Bereich erreicht, ausgebildet ist, wobei jeder opake Bereich wenigstens einen angrenzenden transparenten Bereich aufweist, so dass eine Abfolge von opaken Bereichen und transparenten Bereichen in der Maske erzielt wird.

**2.** Bewegungserfassungsvorrichtung nach Anspruch 1, wobei, wenn die Mehrelement-Fotodiode eine Vielzahl von abgedeckten Megapixeln umfasst, die zum Abdecken des empfindlichen Bereichs von jedem abgedeckten Megapixel der Mehrelement-Fotodiode verwendeten Masken identisch sind.

**3.** Bewegungserfassungsvorrichtung nach Anspruch 1, wobei, wenn die Mehrelement-Fotodiode eine Vielzahl von abgedeckten Megapixeln umfasst, verschiedene Masken für wenigstens zwei abgedeckte Megapixel der Mehrelement-Fotodiode verwendet werden.

**4.** Bewegungserfassungsvorrichtung nach Anspruch 1, 2 oder 3, wobei jede Maske ein Schachbrettmuster umfassend opake Bereiche und transparente Bereiche mit identischen Größen umfasst.

**5.** Bewegungserfassungsvorrichtung nach Anspruch 1, 2 oder 3, wobei jede Maske eine anisotrope Maske ist, die eine Helligkeitsgradientausrichtung bevorzugt.

**6.** Bewegungserfassungsvorrichtung nach Anspruch 5, wobei jede anisotrope Maske aus einer Abfolge von opaken Bereichen und transparenten Bereichen in der Form von senkrechten Bändern mit einer zu bevorzugenden Helligkeitsgradientausrichtung besteht.

**7.** Bewegungserfassungsvorrichtung nach Anspruch 1, wobei jede Maske adaptiv ist und die Bewegungserfassungsvorrichtung eine Steuervorrichtung (110) umfasst, die jede Maske an die Form- und Größenentwicklungen eines Objekts, dessen Bewegung zu erfassen ist, anpasst.

**8.** Bewegungserfassungsvorrichtung nach Anspruch 1, wobei jede Maske adaptiv ist und die Bewegungserfassungsvorrichtung eine Steuervorrichtung (110) umfasst, die zum Anpassen jeder Maske an einen Inhalt einer Szene ausgebildet ist, in der eine Bewegung zu erfassen ist, wobei die Szene einem von der Bewegungserfassungsvorrichtung empfangenen Lichtbündel entspricht, wobei der Inhalt der Szene durch Umrisse von in der Szene enthaltenen Objekten dargestellt ist, wobei Bereiche von jeder den Umrissen entsprechenden Maske durch transparente Bereiche umgesetzt werden und Bereiche von jeder nicht den Umrissen entsprechenden Maske durch opake Bereiche umgesetzt werden.

**9.** Bewegungserfassungsvorrichtung nach Anspruch 1, wobei jede Maske eine adaptive anisotrope Maske ist und die Bewegungserfassungsvorrichtung eine Steuervorrichtung (110) umfasst, die zum Anpassen jeder Maske an wenigstens ein durch die Steuervorrichtung erfasstes Merkmal einer Bewegung ausgebildet ist.

**10.** Vorrichtung nach Anspruch 9, wobei das oder wenigstens eines der Merkmale einer Bewegung repräsentativ für eine Bewegung für eine Szene ist, in der eine Bewegung zu erfassen ist, wobei das oder wenigstens eines der Merkmale durch ein Bewegungsschätzungsverfahren erfasst werden, wobei die Szene einem von der Bewegungserfassungsvorrichtung empfangenen Lichtbündel entspricht.

**11.** Vorrichtung nach Anspruch 10, wobei das oder wenigstens eines der Merkmale einer Bewegung eine Menge von Bewegungsvektoren von Pixelblöcken eines für die Szene repräsentativen Bildes ist, wobei die adaptive anisotrope Maske in Bereiche unterteilt ist, wobei jeder Bereich einem der Pixelblöcke entspricht, wobei die adaptive anisotrope Maske in jedem Bereich so angepasst wird, dass jeder Bereich aus einer Abfolge von opaken Bereichen und transparenten Bereichen in der Form von senkrechten Bändern in der Richtung des Bewegungsvektors des Pixelblocks entsprechend dem Bereich besteht.

**12.** Vorrichtung nach einem der Ansprüche 1 bis 6, wobei für ein Megapixel der Mehrelement-Fotodiode die Maske im empfindlichen Bereich des Megapixels ausgeführt ist, entweder in der Form einer auf den empfindlichen Bereich des Megapixels geklebten optischen Platte oder in der Form einer optischen Platte, die, wenn sie einem Lichtbündel ausgesetzt wird, ein Bild der Maske auf den empfindlichen Bereich des Megapixels projiziert.

**13.** Vorrichtung nach einem der Ansprüche 7 bis 11, wobei die adaptive Maske durch ein programmierbares optisches Übertragungselement oder durch ein programmierbares Reflexionselement ausgeführt wird.

**14.** Optoelektronisches System umfassend einen mit einer ersten Signalerfassungsfrequenz funktionierenden Bildsensor (104), wobei jedes vom Bildsensor erfasste Bild repräsentativ für eine Szene ist, und eine Bewegungskompensationsvorrichtung (107), wobei das optoelektronische System eine Bewegungserfassungsvorrichtung (109) nach einem der Ansprüche 1 bis 13, die für Bewegungen der Szene repräsentative Signalwerte mit einer zweiten Signalerfassungsfrequenz höher als die erste Signalerfassungsfrequenz erzeugt, und eine zum Steuern der Bewegungskompensationsvorrichtung entsprechend den für Bewegungen repräsentativen Signalwerten ausgebildete Verarbeitungsvorrichtung (110) umfasst.

**15.** Verfahren zur Verarbeitung von Bewegungen mit hohen Frequenzen in einem optoelektronischen System umfassend einen mit einer ersten Signalerfassungsfrequenz funktionierenden Bildsensor (104), wobei jedes vom Bildsensor erfasste Bild für eine Szene repräsentativ ist,
wobei das Verfahren die folgenden Schritte umfasst:

- Erfassen (601) von für eine Bewegung der Szene repräsentativen Signalwerten durch eine Bewegungserfassungsvorrichtung (109) nach einem der Ansprüche 1 bis 13 zum Erzeugen von für Bewegungen repräsentativen Signalwerten, die das Erfassen von Bildern durch den Bildsensor (104) beeinflussen können, mit einer zweiten Signalerfassungsfrequenz höher als die erste Signalerfassungsfrequenz,
- Ermitteln (602) von für eine Bewegung eines Bildes repräsentativen Werten während des Erfassens durch Bildsensor aus für eine Bewegung der Szene repräsentativen Signalwerten, wobei das Ermitteln einen Matrixvorgang zwischen den für eine Bewegung der Szene repräsentativen Signalwerten und einer Umwandlungsmatrix umfasst, wobei die Umwandlungsmatrix durch ein Erfassungsverfahren umfassend eine Simulation (701, 705) von für durch die Bewegungserfassungsvorrichtung erfassten Bewegungen repräsentativen Signalen erfasst wird, wobei das Erfassungsverfahren Merkmale der Bewegungserfassungsvorrichtung berücksichtigt,
- Übertragen (603) der somit ermittelten für eine Bewegung des Bildes während des Erfassens durch den Bildsensor repräsentativen Werte an eine Bewegungskompensationsvorrichtung (107), damit die Bewegungskompensationsvorrichtung eine Rückwirkung im optoelektronischen System zum Kompensieren der Bewegung des Bildes während des Erfassens durch den Bildsensor ausüben kann.

**16.** Computerprogrammprodukt, umfassend Anweisungen zum Ausführen des Verfahrens nach Anspruch 15 durch eine Vorrichtung, wenn das Programm von einem Prozessor der Vorrichtung ausgeführt wird.

**17.** Speichermittel zum Speichern eines Computerprogramms umfassend Anweisungen zum Ausführen des Verfahrens nach Anspruch 15 durch eine Vorrichtung, wenn das Programm von einem Prozessor der Vorrichtung ausgeführt wird.

**Claims**

**1.** Movement detection device, comprising:

a multi-element photodiode (2000), the multi-element photodiode comprising a plurality of pixels (2001, 2002, 2003, 2004), referred to as megapixels, and

for at least one megapixel of the multi-element photodiode, referred to as an obscured megapixel, a mask (2011, 2012, 2013, 2014) partially obscuring a sensitive zone of said obscured megapixel, the mask consisting of a plurality of zones comprising at least one opaque zone and at least one transparent zone, an opaque zone being able to prevent a light beam from fully reaching portions of the sensitive zone of the obscured megapixel corresponding to said opaque zone, a transparent zone being able to allow a light beam to reach a portion of the sensitive surface of the obscured megapixel corresponding to said transparent zone, each opaque zone having at least one adjacent transparent zone so as to obtain an alternation of opaque zones and transparent zones in the mask.

2. Movement detection device according to claim 1, wherein, when the multi-element photodiode comprises a plurality of obscured megapixels, the masks used for obscuring the sensitive zone of each obscured megapixel of the multi-element photodiode are identical.

3. Movement detection device according to claim 1, wherein, when the multi-element photodiode comprises a plurality of obscured megapixels, different masks are used for at least two obscured megapixels of the multi-element photodiode.

4. Movement detection device according to claim 1, 2 or 3, wherein each mask is a chequerboard pattern comprising opaque zones and transparent zones of identical sizes.

5. Movement detection device according to claim 1, 2 or 3, wherein each mask is an anisotropic mask favouring a brightness gradient orientation.

6. Movement detection device according to claim 5, wherein each anisotropic mask consists of an alternation of opaque zones and transparent zones in the form of bands perpendicular to a brightness gradient orientation to be favoured.

7. Movement detection device according to claim 1, wherein each mask is adaptive and in that the movement detection device comprises a control device (110) adapting each mask according to changes in shape and size of an object the movement of which is to be detected.

8. Movement detection device according to claim 1, wherein each mask is adaptive and in that the movement detection device comprises a control device (110) able to adapt each mask according to a content of a scene in which a movement is to be detected, said scene corresponding to a light beam received by the movement detection device, the content of said scene being represented by contours of objects contained in said scene, zones of each mask corresponding to the contours being implemented by transparent zones and zones of each mask not corresponding to the contours being implemented by opaque zones.

9. Movement detection device according to claim 1, wherein each mask is an adaptive anisotropic mask and in that the movement detection device comprises a control device (110) able to adapt each mask according to at least one characteristic of a movement obtained by the control device.

10. Device according to claim 9, wherein the at least one of said characteristics of a movement represents a movement in a scene in which a movement is to be detected, the or at least one of said characteristics having been obtained by a movement estimation method, said scene corresponding to a light beam received by the movement detection device.

11. Device according to claim 10, wherein the or at least one of said characteristics of a movement is a set of motion vectors of blocks of pixels of an image representing said scene, the adaptive anisotropic mask being divided into zones, each zone corresponding to one of said blocks of pixels, the adaptive anisotropic mask being adapted in each zone so that each zone consists of an alternation of opaque zones and transparent zones in the form of bands perpendicular to the direction of the motion vector of the block of pixels corresponding to the zone.

12. Device according to any one of claims 1 to 6, wherein, for a megapixel of the multi-element photodiode, the mask is produced on the sensitive zone of the megapixel, or in the form of an optical plate bonded to the sensitive zone of the megapixel, or in the form of an optical plate which, when it is subjected to a light beam, projects an image of the mask onto the sensitive zone of the megapixel.

13. Device according to any one of claims 7 to 11, wherein the adaptive mask is implemented by a programmable optical transmission element or by a programmable reflective element.

14. Optronic system comprising an image sensor (104) functioning with a first signal acquisition frequency, each image obtained by the image sensor representing a scene and a movement compensation device (107), wherein the optronic system comprising a movement detection device (109) according to any one of claims 1 to 13 generating signal values representing movements of said scene with a second signal acquisition frequency higher than the first signal acquisition frequency, and a processing device (110) able to control the movement compensation device according to said signal values representing movements.

15. Method for processing high-frequency movements in an optronic system comprising an image sensor (104) functioning with a first signal acquisition frequency, each image obtained by the image sensor representing a scene, wherein the method comprises the following steps:

- obtaining (601) signal values representing a movement of said scene from a movement detection device (109) according to any of claims 1 to 13 generating signal values representing movements that can affect the acquisition of images by the image sensor (104) with a second signal acquisition frequency, higher than the first signal acquisition frequency,
- determining (602) values representing a movement of an image in the course of acquisition by the image sensor from said signal values representing a movement of said scene, said determination comprising a matrix operation between said signal values representing a movement of said scene and a conversion matrix, the conversion matrix being obtained by an obtaining method comprising a simulation (701, 705) of signals representing movements obtained by the movement detection device, the obtaining method taking into account characteristics of the movement detection device,
- transmission (603) of the values representing a movement of the image being acquired by the image sensor that is determined to a movement compensation device (107) so that said movement compensation device can implement a feedback in the optronic system in order to compensate the movement of the image in the course of acquisition by the image sensor.

16. Computer program product comprising instructions for implementation, by a device, of the method according to claim 15, when said program is executed by a processor of said device.

17. Storage means storing a computer program containing instructions for implementation, by a device, of the method according to claim 15 when said program is executed by a processor of said device.

1002

1001

A

B

C

D

Fig. 1A

A

B

C

D

Fig. 1B

Fig. 2

Fig.3

Fig. 4

Fig. 5

Fig. 6

700

Obtention d'une
image de référence

701

Simulation signal
capteur HF
$(\Delta X_{ref}, \Delta Y_{ref})$

702

n=0

703

Détermination d'un
mouv. pixelique:
$(\Delta x_s(n), \Delta y_s(n))$

704

Obtention image
déplacée I(n)

705

Simulation signal
capteur HF:
$(\Delta X_s(n), \Delta Y_s(n))$

706

n=n+1

707

n<N

Oui     non

708

Détermination
matrice A

Fig. 7

Fig. 8

**EP 3 170 205 B1**

**RÉFÉRENCES CITÉES DANS LA DESCRIPTION**

**Documents brevets cités dans la description**

• US 20020158294 A